# EUROPÄISCHE PATENTSCHRIFT

(11) **EP 3 394 948 B1**
(45) Veröffentlichungstag und Bekanntmachung des Hinweises auf die Patenterteilung: **10.04.2019**
(21) Anmeldenummer: 16816662.7
(22) Anmeldetag: 16.12.2016
(51) Int. Cl.: G01R 31/44, H02J 3/28, G01R 27/18, G01R 31/40, G01R 31/02, G01R 31/42, H02S 50/10

(54) **WECHSELRICHTER MIT NETZTRENNSTELLE UND ISOLATIONSWIDERSTANDSMESSUNG SOWIE VERFAHREN ZUR MESSUNG EINES ISOLATIONSWIDERSTANDES**
INVERTER HAVING NETWORK SEPARATION POINT AND INSULATION RESISTANCE MEASUREMENT, AND METHOD FOR MEASURING AN INSULATION RESISTANCE
ONDULEUR À POINT DE RUPTURE DE RÉSEAU ET MESURE DE RÉSISTANCE D'ISOLEMENT ET PROCÉDÉ DE MESURE D'UNE RÉSISTANCE D'ISOLEMENT

(30) Priorität: 22.12.2015 DE 102015122636
(43) Veröffentlichungstag der Anmeldung: 31.10.2018
(73) Patentinhaber: SMA Solar Technology AG, 34266 Niestetal (DE)
(72) Erfinder: FRIEBE, Jens, 34246 Vellmar (DE); MUELLER, Burkard, 34123 Kassel (DE); PUTZ, Martin, 34119 Kassel (DE)
(86) Internationale Anmeldenummer: PCT/EP2016/081568
(87) Internationale Veröffentlichungsnummer: WO 2017/108633

(56) Entgegenhaltungen:
- EP-A1- 1 857 825
- EP-A1- 2 447 725
- EP-A1- 2 677 330
- EP-A2- 1 887 675
- EP-A2- 2 515 404
- DE-B3-102012 104 752

## Beschreibung

### TECHNISCHES GEBIET DER ERFINDUNG

Die Erfindung betrifft einen Wechselrichter zur Umwandlung elektrischer Leistung einer Energieerzeugungseinheit und Einspeisung der umgewandelten elektrischen Leistung in ein Energieversorgungsnetz, wobei der Wechselrichter eine Netztrennstelle und eine Schaltungsanordnung zur Isolationswiderstandsmessung umfasst, sowie ein Verfahren zur Messung eines Isolationswiderstandes zur Anwendung in einem Wechselrichter.

### STAND DER TECHNIK

Wechselrichter können elektrische Leistung einer Energieerzeugungseinheit von Gleichstrom in Wechselstrom umwandeln und in ein Energieversorgungsnetz, beispielsweise ein Wechselspannungsnetz, einspeisen und/oder einem elektrischen Verbraucher zu dessen Betrieb direkt zuführen. Als Energieerzeugungseinheit können dabei insbesondere Generatoren verwendet werden, die elektrische Leistung aus regenerativen Quellen erzeugen, beispielsweise Photovoltaik- oder Windgeneratoren.

Für einen Anschluss eines Wechselrichters an ein Wechselspannungsnetz ist es aus normativen Gründen notwendig, eine einfehlersichere galvanische Trennung der Energieerzeugungseinheit vom Wechselspannungsnetz zu ermöglichen. Eine solche Trennung kann beispielsweise durch eine in der EP 2 228 895 A1 offenbarte Netztrennstelle gewährleistet werden, die zwei in Reihe geschaltete Relais aufweist.

Aus der EP 1 857 825 A1 ist eine Messanordnung mit einem Erdungspunkt zur Ermittlung des Isolationswiderstands einer unter Spannung stehenden elektrischen Vorrichtung oder einer Anlage mit einer Versorgungsspannung mit einem Pluspol und einem Minuspol bekannt. Dabei sind zwei Schalter oder ein entsprechender Umschalter vorgesehen, die jeweils einen Strompfad zwischen einem der beiden Pole und einem Erdungspunkt herstellen, um bei Auftreten einer oder mehrerer Isolationsfehler mit beliebigem Potentialbezug den sich insgesamt ergebenden Isolationswiderstand zu ermitteln. Zur Ermittlung des Isolationswiderstands werden zwei aufeinanderfolgende Messungen durchgeführt, wobei bei der ersten dieser Messungen der erste Schalter geschlossen ist, während der zweite Schalter geöffnet ist, und wobei bei der zweiten dieser Messungen der erste Schalter geöffnet ist, während der zweite Schalter geschlossen ist. Bei den Messungen wird der über die jeweils hergestellte Verbindung zu dem Erdungspunkt fließende Strom gemessen. Aus den beiden gemessenen Strömen wird der Isolationswiderstand berechnet, wozu die genannte Druckschrift eine detaillierte Anleitung gibt.

Aus der WO 2013/178654 A1 ist ein Wechselrichter mit mindestens einer zwei aktive Schaltelemente aufweisenden Halbbrücke zum Treiben eines Ausgangsstroms und mit einer Vorrichtung zum Messen eines Isolationswiderstands bekannt, wobei die Vorrichtung nacheinander eine Verbindung der beiden ungeerdeten Pole einer Zwischenkreisspannung des Wechselrichters mit einem Erdungspunkt herstellt und einen über die Verbindung zu dem Erdungspunkt fließenden Strom misst. Die Vorrichtung weist einen Erdschalter auf, mit dem ein zwischen den Schaltelementen liegender Mittelpunkt der Halbbrücke mit dem Erdungspunkt verbindbar ist. Die Vorrichtung verbindet den mit dem Erdungspunkt verbundenen Mittelpunkt mittels der Schaltelemente der Halbbrücke nacheinander mit den beiden Polen der an der Halbbrücke anliegenden Zwischenkreisspannung des Wechselrichters, um die Verbindung zum Messen des zu dem Erdungspunkt fließenden Stroms herzustellen.

Die DE 10 2011 018 229 A1 offenbart eine Schaltungsanordnung zur Potentialtrennung eines Wechselrichters einer Energieerzeugungsanlage von einem Netz, die eine Reihenschaltung aus zwei Schaltelementen umfasst, wobei eine Messeinrichtung zum Erfassen eines Potentials oder einer Potentialverschiebung an dem Mittelkontakt zwischen den zwei Schaltelementen der Reihenschaltung vorgesehen ist.

Die DE 10 2013 104 629 A1 offenbart eine Energieerzeugungseinrichtung mit einem Stromrichter und einer Trenneinrichtung zur Potentialtrennung des Stromrichters von einem Netz, wobei die Trenneinrichtung eine Reihenschaltung aus zwei Schalterelementen umfasst. Die Energieerzeugungseinrichtung kann eine Isolationsmesseinrichtung umfassen, um einen Defekt eines der Schalterelemente anhand eines von der Isolationsmesseinrichtung bestimmten Isolationswiderstandes festzustellen, während das jeweils andere der Schalterelemente zum Schließen angesteuert ist.

Die DE 10 2011 122 359 A1 offenbart einen Wechselrichter, dessen ausgangsseitige Phasenleiter jeweils über eine Reihenschaltung aus zwei Schaltkontakten geführt ist, wobei mittels Messvorrichtungen die Werte der Spannungen auf den Phasenleitern erfasst werden können, sowie ein Verfahren zur Funktionsprüfung von elektromechanischen Schaltern.

Die bekannten Messanordnungen können konkret dazu vorgesehen sein, eine Photovoltaikanlage auf einen Isolationsfehler zu überwachen, die elektrische Energie von einem Photovoltaikgenerator in ein Wechselstromnetz einspeist. Die zur Ausbildung der bekannten Messanordnungen an einem Wechselrichter vorzusehenden Bauteile sind zahlreich und erhöhen die Gesamtkosten des Wechselrichters erheblich.

DE-B3-102012104752 offenbart einen Wechselrichter nach dem Oberbegriff des Anspruchs 1.

### AUFGABE DER ERFINDUNG

Der Erfindung liegt die Aufgabe zugrunde, einen Wechselrichter mit einer Schaltungsanordnung zur Messung eines Isolationswiderstands und ein Verfahren zur Ermittlung eines Isolationswiderstandes eines Wechselrichters aufzuzeigen, mit denen eine aktive Messung des Isolationswiderstandes mit einer geringeren Anzahl an zusätzlichen Bauteilen und damit kostensparend möglich ist.

### LÖSUNG

Die Aufgabe wird durch einen Wechselrichter mit den Merkmalen des Patentanspruchs 1 sowie durch ein Verfahren mit den Merkmalen des Patentanspruchs 6 gelöst. Bevorzugte Ausführungsformen sind in den abhängigen Patentansprüchen definiert.

### BESCHREIBUNG DER ERFINDUNG

Ein erfindungsgemäßer Wechselrichter mit einer Schaltungsanordnung zur Messung eines Isolationswiderstandes weist mindestens eine Halbbrücke mit mindestens zwei Schaltelementen und eine Netztrennstelle mit einer Reihenschaltung aus zwei Trenneinrichtungen auf, wobei die Reihenschaltung zwischen einem Mittelpunkt der Halbbrücke und einem für ein Anschließen eines Phasenleiters oder eines Nullleiters eines Wechselspannungsnetzes vorgesehenen Wechselspannungsanschluss des Wechselrichters angeordnet ist. Die Schaltungsanordnung zur Messung des Isolationswiderstandes weist einen Widerstand und eine Spannungsmessvorrichtung auf, wobei der Widerstand elektrisch parallel zu einer der Trenneinrichtungen und die Spannungsmessvorrichtung zwischen dem ausgangsseitigen Anschluss des Widerstandes und einem der Endpunkte der Halbbrücke angeordnet ist.

Diese Lösung basiert auf der Erkenntnis, dass es zur Ermittlung des Isolationswiderstandes des Wechselrichters nicht zwingend notwendig ist, eine Spannungs- oder Strommessung mit Bezug auf den Erd- oder Schutzleiter durchzuführen, wie es aus dem Stand der Technik bekannt ist. Vielmehr erweist es sich als vorteilhaft, sowieso vorhandene Bauteile des Wechselrichters, namentlich die Trenneinrichtungen der Netztrennstelle, um einen Messwiderstand zu ergänzen und derart zu nutzen, dass eine Spannungsmessung mit Bezug auf einen Phasenleiter oder einen Nullleiter des Wechselspannungsnetzes duchgeführt wird. Diese Messung ist für die Ermittlung des Isolationswiderstandes nutzbar, wenn und insoweit die Potentialdifferenz zwischen dem Phasenleiter bzw. dem Nullleiter und dem Erd- oder Schutzleiter nahe null oder zumindest weitgehend konstant ist und sich im Rahmen der an der Halbbrücke des Wechselrichters anliegenden Eingangsspannung bewegt. Insbesondere für Frequenzen deutlich unterhalb der Netzfrequenz und erst recht für Gleichspannungen mit einer Frequenz gleich null erfüllt die Potentialdifferenz zwischen dem Phasenleiter bzw. dem Nullleiter und dem Erd- oder Schutzleiter regelmäßig die genannte Bedingung, die darüber hinaus mit einfachen Mittels anhand einer zusätzlichen Messung der Potentialdifferenz zwischen dem Erd- oder Schutzleiter und dem zur Ermittlung des Isolationswiderstandes genutzten Endpunkt der Halbbrücke verifiziert werden kann.

In einer Ausführungsform des Wechselrichters können die Trenneinrichtungen als Relais ausgeführt sind, um eine galvanische Trennung einer gleichspannungsseitig des Wechselrichters angeordnete Energieerzeugungseinheit von dem Wechselspannungsnetz zu ermöglichen. Dabei können die Trenneinrichtungen in Form einer Reihenschaltung zwischen dem Mittelpunkt der Halbbrücke und dem Wechselspannungsanschluss angeordnet sein, um insbesondere eine kompakte Bauform der Netztrennstelle zu ermöglichen. Der Widerstand kann parallel zu einer ersten Trenneinrichtung und parallel zu einer zweiten Trenneinrichtung der Reihenschaltung angeordnet sein. Die Spannungsmessvorrichtung kann zwischen dem ausgangsseitigen Anschluss des Widerstandes und wahlweise einem der Anschlüsse des Gleichspannungszwischenkreises angeordnet sein, d.h. zwischen dem ausgangsseitigen Anschluss des Widerstandes und dem einem positiven Anschluss eines Gleichspannungszwischenkreises zugeordneten Endpunkt oder dem einem negativem Anschluss des Gleichspannungszwischenkreises zugeordneten Endpunkt der Halbbrücke.

In einer konkreten Ausführungsform ist der Wechselrichter dazu eingerichtet ist, elektrische Leistung von einer an die Endpunkte der Halbbrücke anschließbaren Energiequelle in ein an den Wechselspannungsanschluss des Wechselrichters anschließbares Wechselspannungsnetz einzuspeisen. Dies bedeutet, dass die einzuspeisende elektrische Leistung über die Netztrennstelle fließt, deren Trenneinrichtungen dazu in einen leitenden Zustand geschaltet sein müssen. Zugleich weisen die Trenneinrichtungen der Netztrennstelle zur Messung des Isolationswiderstandes einen Schaltzustand auf, der bei herkömmlichen Wechselrichtern keinen Sinn ergibt, indem eines der in Reihe geschalteten Trenneinrichtungen in einem nicht-leitenden Zustand und ein weiteres Trenneinrichtungen in einem leitenden Zustand ist.

Ein erfindungsgemäßes Verfahren bezieht sich auf einen Wechselrichter mit mindestens einer Halbbrücke, die mindestens zwei Schaltelemente aufweist, einem parallel zu der Halbbrücke angeordneten Gleichspannungszwischenkreis mit einem ersten und einem zweiten Pol, einer Netztrennstelle, die eine Reihenschaltung aus zweit Trenneinrichtungen aufweist, wobei die Reihenschaltung zwischen einem Mittelpunkt der Halbbrücke und einem für ein Anschließen eines Phasenleiters oder eines Nullleiters eines Wechselspannungsnetzes vorgesehenen Wechselspannungsanschluss angeordnet ist, und einer Schaltungsanordnung zur Ermittlung eines Isolationswiderstandes, die einen elektrisch parallel zu einer der Trenneinrichtungen angeordneten Widerstand umfasst. Das Verfahren ist dadurch gekennzeichnet, dass in einem ersten Schritt diejenige Trenneinrichtung, zu der der Widerstand parallel angeordnet ist, in einen nicht-leitenden und die andere Trenneinrichtung in einen leitenden Zustand geschaltet wird. In diesem Schaltzustand wird ein erster Spannungswert einer Spannung gemessen, die zwischen einem ausgangsseitigen Anschluss des Widerstands und einem ersten Pol des Gleichspannungszwischenkreises abfällt, während der erste Pol des Gleichspannungszwischenkreises mit dem Wechselspannungsanschluss verbunden ist, und es wird ein zweiter Spannungswertes der Spannung gemessen, die zwischen dem ausgangsseitigen Anschluss des Widerstandes und dem ersten Pol des Gleichspannungszwischenkreises abfällt, während der zweite Pol des Gleichspannungszwischenkreises mit dem Wechselspannungsanschluss verbunden ist. Der Isolationswiderstand wird dann in Abhängigkeit von den gemessenen Spannungswerten ermittelt. Die Reihenfolge, in der der erste Spannungswert und der zweite Spannungswert bestimmt werden, ist hierbei beliebig.

In einer Ausführungsform des Verfahrens werden der erste Pol und der zweite Pol des Gleichspannungszwischenkreises jeweils mit dem Wechselspannungsanschluss verbunden, indem ein erstes bzw. ein zweites der Schaltelemente der Halbbrücke in einen leitenden Zustand geschaltet wird. Die Verbindung des ersten Pols bzw. des zweiten Pols des Gleichspannungszwischenkreises mit dem Wechselspannungsanschluss kann abwechselnd und insbesondere wiederholt mit einer Frequenz vorgenommen werden, die um mindestens einen Faktor 10 unterhalb der Netzfrequenz des Wechselspannungsnetzes liegt, wobei zusätzlich beim Messen des ersten und des zweiten Spannungswertes netzfrequente Anteile aus den Spannungsmesswerten herausgefiltert werden können.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt eine erste Ausführungsform eines erfindungsgemäßen Wechselrichters mit einer Netztrennstelle und einer Schaltungsanordnung zur Ermittlung eines Isolationswiderstandes,
- Fig. 2: zeigt eine zweite Ausführungsform eines erfindungsgemäßen Wechselrichters,
- Fig. 3: zeigt eine dritte Ausführungsform eines erfindungsgemäßen Wechselrichters, und
- Fig. 4: zeigt ein Blockdiagramm zur Visualisierung einer Ausführungsform des erfindungsgemäßen Verfahrens.

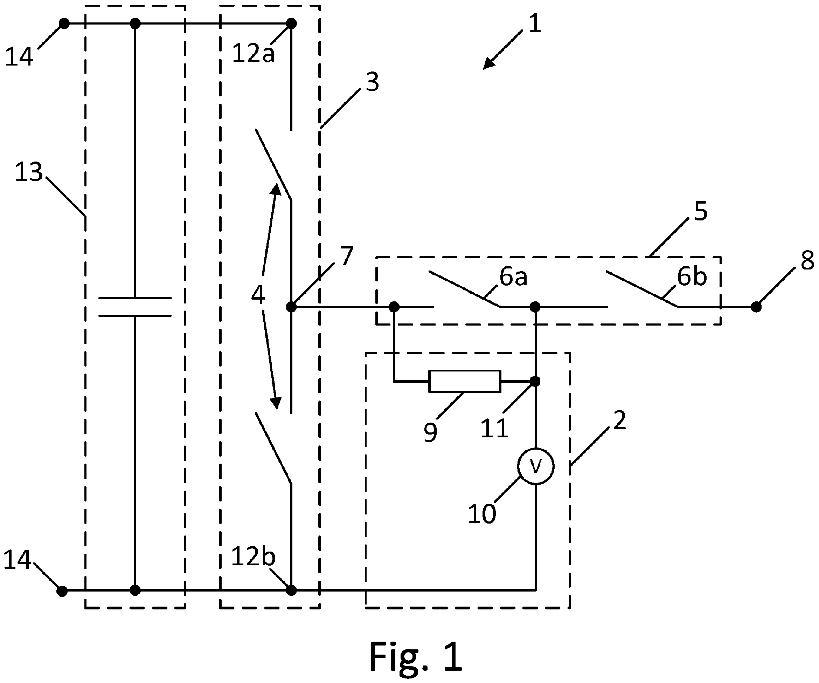

**Fig. 1** zeigt einen erfindungsgemäßen Wechselrichter 1, der eingangsseitige Gleichspannungsanschlüsse 14 aufweist, an die eine Gleichspannungsquelle, beispielsweise ein Photovoltaikgenerator angeschlossen werden kann, wobei die Gleichspannungsquelle direkt oder über einen zwischengeschalteten Gleichspannungswandler mit dem Wechselrichter 1 verbunden werden kann. Ein Gleichspannungszwischenkreis 13 dient zur Zwischenspeicherung der über die Gleichspannungsanschlüsse 14 in den Wechselrichter 1 eingespeisten elektrischen Leistung. Parallel zum Gleichspannungszwischenkreis 13 ist eine Halbbrücke 3 mit zwei elektrisch in Reihe geschalteten Schaltelementen 4 angeordnet, wobei Endpunkte 12a, 12b der Halbbrücke 3 jeweils mit den Polen des Gleichspannungszwischenkreis 13 und den Gleichspannungsanschlüssen 14 verbunden sind. Durch getaktetes, insbesondere wechselseitiges Schalten der Schaltelemente 4 kann eine an den Gleichspannungsanschlüssen 14 anliegende Gleichspannung in eine getaktete Wechselspannung umgewandelt werden, die an dem Mittelpunkt 7 der Halbbrücke 3 abgegriffen werden kann, so dass nach einer Glättung über hier nicht dargestellte Ausgangsfilter ein sinusförmiger Wechselstrom erzeugt und über einen Wechselspannungsanschluss 8 in ein hier nicht dargestelltes Wechselspannungsnetz eingespeist werden kann. Zur Trennung des Wechselrichters 1 vom Wechselspannungsnetz ist eine Trennstelle 5 vorgesehen, die zwischen dem Mittelpunkt 7 der Halbbrücke 3 und dem Wechselspannungsanschluss 8 angeordnet ist. Aus normativen Gründen, insbesondere zur Gewährleistung der sogenannten Einfehlersicherheit, besteht eine solche Trennstelle insbesondere bei transformatorlosen Wechselrichtern regelmäßig aus mindestens zwei elektrisch in Reihe geschalteten Trenneinrichtungen 6a, 6b.

Zur Ermittlung eines Isolationswiderstandes des Wechselrichters 1 ist eine Schaltungsanordnung 2 mit einem Widerstand 9 und einer Spannungsmessvorrichtung 10 vorgesehen. Der Widerstand 9 ist parallel zum brückenseitigen Trennelement 6a der Netztrennstelle 5 angeordnet. Die Spannungsmessvorrichtung 10 ist zwischen einem ausgangsseitigen Anschluss 11 des Widerstandes 9 und dem Endpunkt 12b der Halbbrücke 4 angeordnet.

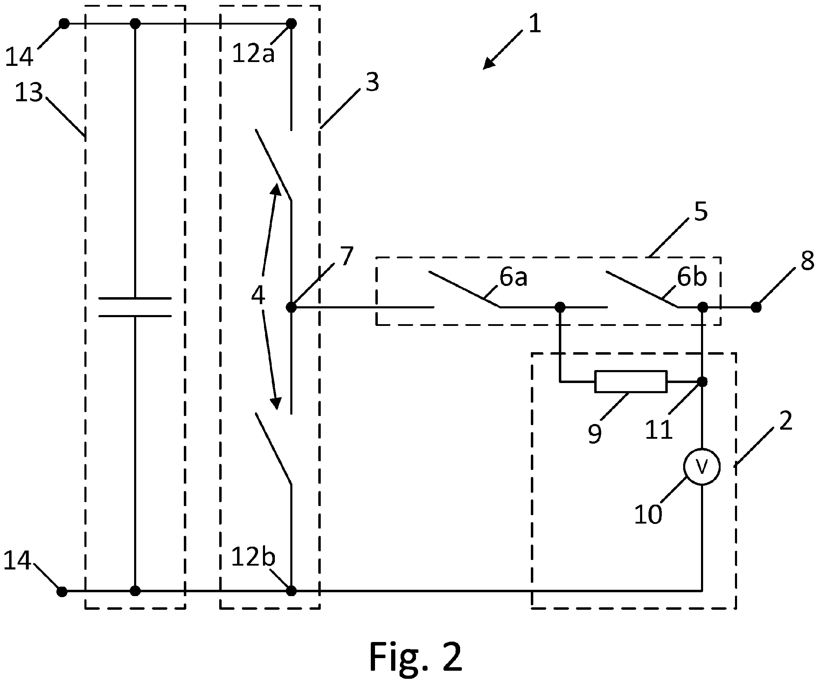

Fig. 2 zeigt eine alternative Ausführungsform eines erfindungsgemäßen Wechselrichters 1. Im Unterschied zu Fig. 1 ist gemäß Fig. 2 der Widerstand 9 parallel zur ausgangsseitigen Trenneinrichtung 6b angeordnet angeordnet. Die Spannungsmessvorrichtung 10 ist weiterhin zwischen dem ausgangsseitigen Anschluss 11 des Widerstandes 9 und dem Endpunkt 12b der Halbbrücke 4 angeordnet.

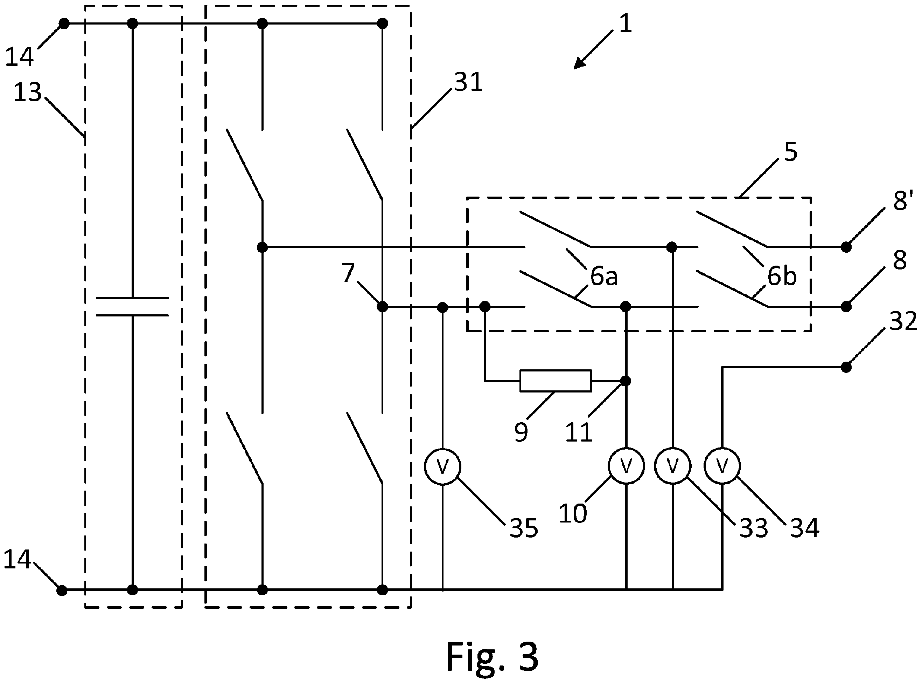

**Fig. 3** zeigt eine weitere Ausführungsform des Wechselrichters 1. In dieser Ausführungsform umfasst der Wechselrichter eine Wechselrichterbrücke 31, die hier als H4-Brücke mit zwei Halbbrücken mit jeweils zwei Schaltelementen ausgebildet ist und elektrische Leistung, die von einem an die Gleichspannungsanschlüsse 14 anschließbaren Generator zur Verfügung gestellt wird, als Wechselstrom über die Wechselspannungsanschlüsse 8, 8' ausgeben und in ein daran anschließbares Wechselspannungsnetz einspeisen kann. Die Wechselspannungsanschlüsse 8, 8' sind dabei für den Anschluss eines Phasenleiters und eines Neutralleiters des Wechselspannungsnetzes vorgesehen und können über die Netztrennstelle 5 von der Wechselrichterbrücke 31 und damit vom Generator getrennt werden, wobei für die Wechselspannungsanschlüsse 8, 8' jeweils zwei in Reihe geschaltete Trenneinrichtungen 6a, 6b vorgesehen sind. Für den Anschluss eines Schutz- oder Erdleiter (PE-Leiter) des Wechselspannungsnetzes kann ein PE-Anschluss 32 vorgesehen sein. Zur Ermittlung des Isolationswiderstandes ist ein parallel zu einem der wechselrichterseitigen Trenneinrichtungen 6a angeordneter Widerstand 9 vorgesehen, wobei eine Spannungsmesseinrichtung 10 zwischen dem ausgangsseitigen Anschluss des Widerstandes 9 und einem Endpunkt der Wechselrichterbrücke 31 angeordnet ist (vergleiche Fig. 1). Weitere Spannungsmesseinrichtungen 33, 34, 35 können vorgesehen sein, um Spannungen zwischen einem Endpunkt der Wechselrichterbrücke 31 und dem Wechselspannungsanschluss 8a, dem PE-Leiter bzw. einem Mittelpunkt zwischen einem Zweig der Wechselrichterbrücke 31 und der Netztrennstelle 5 zu erfassen.

Die Netztrennstelle 5 ist dazu eingerichtet, eine an den Gleichspannungsanschlüssen 14 angeschlossene Gleichspannungsquelle derart von dem Wechselspannungsanschluss 8 abzutrennen, dass eine galvanische Trennung auch bei einem etwaigen Ausfall von einer der Trenneinrichtungen 6a, 6b, d.h. bei einem dauerhaften Verbleiben einer der Trenneinrichtungen 6a, 6b in einem leitenden Zustand gewährleistet ist. Diese sogenannte Einfehlersicherheit kann auch dadurch erzielt werden, dass die ausgangsseitige Trenneinrichtung 6b abweichend zur Konfiguration gemäß den Figuren 2 und 3 in zwei einzelne Trenneinrichtungen aufgeteilt ist, die jeweils in den Gleichstromleitungen zwischen den Gleichstromanschlüssen 14 und den Endpunkten der Halbbrücke 3 bzw. der Wechselrichterbrücke 31 angeordnet sind. Auch dadurch kann gewährleistet werden, dass die Gleichspannungsquelle allpolig von den Wechselspannungsanschlüssen 8, 8' getrennt ist, selbst wenn eine der verbleibenden Trenneinrichtungen 6a, 6b aufgrund eines etwaigen Fehlerzustandes nicht mehr geöffnet werden kann. Diese Anordnung kann vorteilhafterweise zusätzlich die Halbbrücke 3 bzw. die Wechselrichterbrücke 31 vor gleichspannungsseitig auftretenden Überspannungen schützen. Im Übrigen handelt es sich bei einem solchen zur Fig. 3 äquivalenten "verteilten" Aufbau der Netztrennstelle 5 nach wie vor um eine Reihenschaltung von einer ersten, gleichstromseitigen Trenneinrichtung und einer zweiten, netzseitigen Trenneinrichtung, wobei zwischen der ersten und der zweiten Trenneinrichtung eine Wechselrichterbrückenschaltung 31 angeordnet ist. In diesem Zusammenhang sei erwähnt, dass der Widerstand 9 bei geeigneter Auswahl, insbesondere bei ausreichend hohem Widerstandswert, ebenfalls die Anforderung einer galvanischen Trennung erfüllt, insbesondere wenn ein Schutzwiderstand als Widerstand 9 eingesetzt wird.

Der Widerstand 9 kann auch durch eine geeignete Konfiguration der Spannungsmessvorrichtungen 10 und 35 ausgebildet werden. Diese Spannungsmessvorrichtungen 10 und 35 weisen Innenwiderstände auf, die in Kombination miteinander denselben Effekt wie ein separater Widerstand 9 hinsichtlich der Ermittlung des Isolationswiderstandes ergeben können, so dass in diesem Fall auf einen dezidierten Widerstand 9 verzichtet werden kann.

Es versteht sich, dass die Wechselrichterbrücke 31 alternativ zu der in Fig. 3 dargestellten H4-Brücke auch als sogenannte H5-Brücke gemäß der DE 10 2004 030 912 A1 ausgeführt oder einen Freilauf gemäß der EP 1 369 985 A1 aufweisen kann. Darüber hinaus kann die Wechselrichterbrücke 31 dreiphasig ausgeführt sein, so dass der Wechselrichter 1 einen Drehstrom in ein dreiphasiges Wechselspannungsnetz einspeisen kann. Die einzelnen Halbbrücken 3 des Wechselrichters 1 können als 3-Level- oder Mehrlevel-Halbbrücken ausgeführt sein, wobei der Gleichspannungszwischenkreis 13 mehrere Kapazitäten und ggf. einen Mittelpunktsabgriff aufweisen kann.

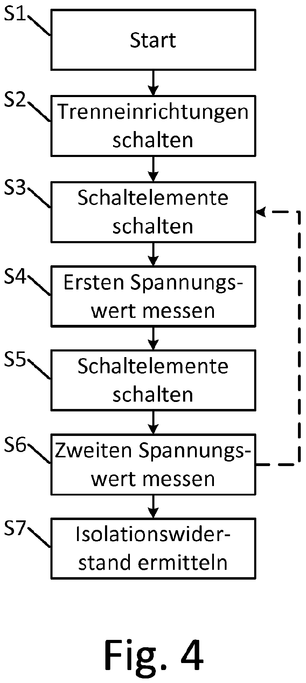

Fig. 4 zeigt ein Blockdiagramm zur Visualisierung einer Ausführungsform des erfindungsgemäßen Verfahrens. Nach einem Start des Wechselrichters 1 in Schritt S1 werden in Schritt S2 die Trenneinrichtungen 6a, 6b derart geschaltet, dass sich diejenige der Trenneinrichtungen 6a, 6b, zu der der Widerstand parallel angeordnet ist, in einem nicht-leitenden und die andere der Trenneinrichtungen 6b, 6a in einem leitenden Zustand befindet. In Schritt S3 werden die Schaltelemente 4 der Halbbrücke 3 bzw. der Wechselrichterbrücke 31 derart geschaltet, dass ein erster Pol 12a oder 12b des Gleichspannungszwischenkreises 13 mit dem Wechselspannungsanschluss 8 verbunden ist, so dass in Schritt S4 ein erster Spannungswert einer Spannung V, die zwischen einem ausgangsseitigen Anschluss 11 des Widerstands 9 und dem ersten Pol 12a bzw. 12b des Gleichspannungszwischenkreises 13 abfällt, gemessen werden kann. In Schritt S6 werden die Schaltelemente 4 der Halbbrücke 3 bzw. der Wechselrichterbrücke 31 derart geschaltet, dass der zweite, d.h. der andere Pol 12b bzw. 12a des Gleichspannungszwischenkreises 13 mit dem Wechselspannungsanschluss 8 verbunden ist, so dass in Schritt S5 ein zweiter Spannungswertes der Spannung V, die zwischen dem ausgangsseitigen Anschluss 11 des Widerstands 9 und dem ersten Pol 12a bzw. 12b des Gleichspannungszwischenkreises 13 abfällt, gemessen werden kann. Aus den gemessenen Spannungswerten kann dann in Schritt S7 in bekannter Art und Weise der Isolationswiderstand des Wechselrichters ermittelt werden. Optional können die Schritte S3 bis S6 in Form einer Schleife mehrfach durchgeführt werden, wobei die Zeitdauer eines Durchlaufes mindestens um den Faktor 10 länger als eine Netzperiode sein kann.

### Bezugszeichenliste

- 1: Wechselrichter
- 2: Schaltungsanordnung
- 3: Halbbrücke
- 4: Schaltelement
- 5: Netztrennstelle
- 6a, 6b: Trenneinrichtung
- 7: Mittelpunkt
- 8, 8': Wechselspannungsanschluss
- 9: Widerstand
- 10: Spannungsmessvorrichtung
- 11: Anschluss
- 12a, 12b: Endpunkte
- 13: Gleichspannungszwischenkreis
- 14: Gleichspannungsanschluss
- 31: Wechselrichterbrücke
- 32: PE-Anschluss
- 33, 34, 35: Spannungsmessvorrichtung

## Patentansprüche

1. Wechselrichter (1) mit einer Schaltungsanordnung (2) zur Messung eines Isolationswiderstandes, wobei der Wechselrichter (1) mindestens eine Halbbrücke (3) mit mindestens zwei Schaltelementen (4) und eine Netztrennstelle (5) mit einer Reihenschaltung aus zwei Trenneinrichtungen (6a, 6b) aufweist, wobei die Reihenschaltung zwischen einem Mittelpunkt (7) der Halbbrücke (3) und einem für ein Anschließen eines Phasenleiters oder eines Nullleiters eines Wechselspannungsnetzes vorgesehenen Wechselspannungsanschluss (8) des Wechselrichters (1) angeordnet ist, und wobei die Schaltungsanordnung einen Widerstand (9) und eine Spannungsmessvorrichtung (10) aufweist, **dadurch gekennzeichnet, dass** der Widerstand (9) elektrisch parallel zu einer der Trenneinrichtungen (6a, 6b) und die Spannungsmessvorrichtung (10) elektrisch zwischen dem ausgangsseitigen Anschluss (11) des Widerstandes (9) und einem der Endpunkte (12a, 12b) der Halbbrücke (4) angeordnet ist.

2. Wechselrichter (1) nach Anspruch 1, **dadurch gekennzeichnet, dass** die Trenneinrichtungen (6a, 6b) als Relais ausgeführt sind.

3. Wechselrichter (1) nach Anspruch 1 oder 2, **dadurch gekennzeichnet, dass** der Widerstand (9) parallel zu einer ersten Trenneinrichtung (6a) oder parallel zu einer zweiten Trenneinrichtung (6b) der Reihenschaltung zwischen dem Mittelpunkt (7) der Halbbrücke (3) und dem Wechselspannungsanschluss (8) angeordnet ist.

4. Wechselrichter (1) nach einem der Ansprüche 1 bis 3, **dadurch gekennzeichnet, dass** die Spannungsmessvorrichtung (10) zwischen dem ausgangsseitigen Anschluss (11) des Widerstandes (9) und dem einem positiven Anschluss eines Gleichspannungszwischenkreises (13) zugeordneten Endpunkt (12a) oder dem einem negativem Anschluss des Gleichspannungszwischenkreises (13) zugeordneten Endpunkt (12b) der Halbbrücke (3) angeordnet ist.

5. Wechselrichter (1) nach einem der vorangehenden Ansprüche, **dadurch gekennzeichnet, dass** der Wechselrichter (1) dazu eingerichtet ist, elektrische Leistung von einer an die Endpunkte (12a, 12b) der Halbbrücke (3) anschließbaren Energiequelle in ein an den Wechselspannungsanschluss (8) des Wechselrichters (1) anschließbares Wechselspannungsnetz einzuspeisen.

6. Verfahren zur Ermittlung eines Isolationswiderstandes eines Wechselrichters (1) mit
- mindestens einer Halbbrücke (3), die mindestens zwei Schaltelemente (4) aufweist,
- einem parallel zu der Halbbrücke (3) angeordneten Gleichspannungszwischenkreis (13) mit einem ersten und einem zweiten Pol,
- einer Netztrennstelle (5), die eine Reihenschaltung aus zwei Trenneinrichtungen (6a, 6b) aufweist, wobei die Reihenschaltung zwischen einem Mittelpunkt (7) der Halbbrücke (3) und einem für ein Anschließen eines Phasenleiters oder eines Nullleiters eines Wechselspannungsnetzes vorgesehenen Wechselspannungsanschluss (8) des Wechselrichters (1) angeordnet ist, und
- einer Schaltungsanordnung (2) zur Ermittlung eines Isolationswiderstandes, die einen elektrisch parallel einer der Trenneinrichtungen (6a, 6b) angeordneten Widerstand (9) umfasst, **dadurch gekennzeichnet, dass** das Verfahren folgende Schritte aufweist:
- Schalten derjenigen der Trenneinrichtungen (6a, 6b), zu der der Widerstand (9) parallel angeordnet ist, in einen nicht leitenden und die andere der Trenneinrichtungen (6b, 6a) in einen leitenden Zustand,
- Messen eines ersten Spannungswertes einer Spannung (V), die zwischen einem ausgangsseitigen Anschluss (11) des Widerstands (9) und dem ersten Pol des Gleichspannungszwischenkreises (13) abfällt, während der erste Pol des Gleichspannungszwischenkreises (13) mit dem Wechselspannungsanschluss (8) verbunden ist,
- Messen eines zweiten Spannungswertes der Spannung (V), die zwischen dem ausgangsseitigen Anschluss (11) des Widerstands (9) und dem ersten Pol des Gleichspannungszwischenkreises (13) abfällt, während der zweite Pol des Gleichspannungszwischenkreises (13) mit dem Wechselspannungsanschluss (8) verbunden ist, und
- Ermitteln des Isolationswiderstandes in Abhängigkeit von den gemessenen Spannungswerten.

7. Verfahren nach Anspruch 6, **dadurch gekennzeichnet, dass** der erste Pol und der zweite Pol des Gleichspannungszwischenkreises (13) jeweils mit dem Wechselspannungsanschluss (8) verbunden werden, indem ein erstes bzw. ein zweites der Schaltelemente (4) der Halbbrücke (3) in einen leitenden Zustand geschaltet wird.

8. Verfahren nach einem der vorangehenden Ansprüche 6 bis 7, **dadurch gekennzeichnet, dass** die Verbindung des ersten Pols bzw. des zweiten Pols des Gleichspannungszwischenkreises (13) mit dem Wechselspannungsanschluss (8) abwechselnd mit einer Frequenz vorgenommen wird, die um mindestens einen Faktor 10 unterhalb der Netzfrequenz liegt, und dass beim Messen des ersten und des zweiten Spannungswertes netzfrequente Anteile herausgefiltert werden.

## Claims

1. Inverter (1) comprising a circuit arrangement (2) for measuring an insulation resistance, the inverter (1) comprising at least one half-bridge (3) with at least two switching elements (4) and a mains disconnection unit (5) with a series connection of two disconnection devices (6a, 6b), the series connection being arranged between a center point (7) of the half-bridge (3) and an AC voltage terminal (8) of the inverter(1) which is provided for connecting a phase conductor or a neutral conductor of an AC voltage network, and the circuit arrangement comprising a resistor (9) and a voltage measuring device (10), **characterized in that** the resistor (9) is electrically parallel to one of the isolating devices (6a, 6b) and the voltage measuring device (10) is electrically arranged between the output terminal (11) of the resistor (9) and one of the end points (12a, 12b) of the half-bridge (4).

2. Inverter (1) according to claim 1, **characterized in that** the isolating devices (6a, 6b) are designed as relays.

3. Inverter (1) according to claim 1 or 2, **characterized in that** the resistor (9) is arranged parallel to a first disconnection device (6a) or parallel to a second disconnection device (6b) of the series connection between the center (7) of the half-bridge (3) and the AC voltage connection (8).

4. Inverter (1) according to one of claims 1 to 3, **characterized in that** the voltage measuring device (10) is arranged between the output-side connection (11) of the resistor (9) and the end point (12a) assigned to a positive connection of a DC intermediate circuit (13) or the end point (12b) of the half-bridge (3) assigned to a negative connection of the DC intermediate circuit (13).

5. Inverter (1) according to one of the preceding claims, **characterized in that** the inverter (1) is arranged to feed electrical power from an energy source which can be connected to the end points (12a, 12b) of the half-bridge (3) into an alternating voltage network which can be connected to the alternating voltage terminal (8) of the inverter (1).

6. Method for determining an insulation resistance of an inverter (1) comprising
- at least one half-bridge (3) which comprises at least two switching elements (4),
- a DC voltage intermediate circuit (13) arranged parallel to the half-bridge (3) and having a first and a second pole,
- a mains disconnection point (5) which has a series connection of two disconnection devices (6a, 6b), the series connection being arranged between a center (7) of the half-bridge (3) and an AC voltage terminal (8) of the inverter (1) which is provided for connecting a phase conductor or a neutral conductor of an AC voltage network, and
- a circuit arrangement (2) for determining an insulation resistance, which comprises a resistor (9) arranged electrically in parallel with one of the isolating devices (6a, 6b), **characterized in that** the method has the following steps:
- switching that one of the disconnection devices (6a, 6b) to which the resistor (9) is arranged in parallel into a non-conductive state and the other of the disconnection devices (6b, 6a) into a conductive state,
- measuring a first voltage value of a voltage (V) which drops between an output-side terminal (11) of the resistor (9) and the first pole of the DC voltage intermediate circuit (13) while the first pole of the DC voltage intermediate circuit (13) is connected to the AC voltage terminal (8),
- measuring a second voltage value of the voltage (V) which drops between the output terminal (11) of the resistor (9) and the first pole of the DC voltage intermediate circuit (13) while the second pole of the DC voltage intermediate circuit (13) is connected to the AC voltage terminal (8), and
- determining the insulation resistance as a function of the measured voltage values.

7. Method according to claim 6, **characterized in that the** first pole and the second pole of the DC intermediate circuit (13) are each connected to the AC terminal (8) by switching a first and a second, respectively, of the switching elements (4) of the half-bridge (3) into a conductive state.

8. Method according to one of the preceding claims 6 to 7, **characterized in that** the connection of the first pole or the second pole, respectively, of the DC intermediate circuit (13) to the AC terminal (8) is carried out alternately with a frequency which is at least a factor 10 below the mains frequency, and **in that** mains frequency components are filtered out when measuring the first and the second voltage value.

## Revendications

1. Onduleur (1) comportant un circuit (2) pour mesurer une résistance d'isolement, l'onduleur (1) comportant au moins un demi-pont (3) avec au moins deux éléments de commutation (4) et un point de coupure de réseau (5) avec une connexion en série de deux dispositifs de coupure (6a, 6b), la connexion en série étant disposée entre un point central (7) du demi-pont (3) et une borne de tension alternative (8) du onduleur (1) qui est prévue pour relier une phase ou un conducteur neutre d'une tension alternative, et le circuit comprenant une résistance (9) et un dispositif de mesure de tension (10), **caractérisé en ce que** la résistance (9) est électriquement parallèle à l'un des dispositifs d'isolation (6a, 6b) et le dispositif de mesure de tension (10) est électriquement disposé entre la borne de sortie (11) de la résistance (9) et un des points terminaux (12a, 12b) du demi-bridge (4).

2. Onduleur (1) selon la revendication 1, **caractérisé en ce que** les dispositifs d'isolation (6a, 6b) sont conçus comme relais.

3. Onduleur (1) selon la revendication 1 ou 2, **caractérisé en ce que** la résistance (9) est disposée parallèlement à un premier dispositif d'isolation (6a) ou parallèlement à un second dispositif d'isolation (6b) de la liaison série entre le centre (7) du demi-pont (3) et la liaison tension alternative (8).

4. Onduleur (1) selon l'une des revendications 1 à 3, **caractérisé en ce que** le dispositif de mesure de tension (10) est disposé entre la connexion côté sortie (11) de la résistance (9) et le point final (12a) affecté à une connexion positive d'un circuit intermédiaire CC (13) ou le point final (12b) du demi-pont (3) affecté à une connexion négative du circuit intermédiaire CC (13).

5. Onduleur (1) selon l'une des revendications précédentes, **caractérisé en ce que** l'onduleur (1) est agencé pour alimenter en énergie électrique une source d'énergie qui peut être raccordée aux points terminaux (12a, 12b) du demi-pont (3) dans un réseau à tension alternative qui peut être relié à la borne (8) de tension alternative du onduleur (1).

6. Procédé de détermination d'une résistance d'isolement d'un onduleur (1) comportant au moins un demi-pont (3) qui comporte au moins deux éléments de commutation (4),
- un circuit intermédiaire de tension continue (13) disposé parallèlement au demi-pont (3) et ayant un premier et un second pôle,
- un point de coupure de réseau (5) qui présente une connexion en série de deux dispositifs de coupure (6a, 6b), la connexion en série étant disposée entre un centre (7) du demi-pont (3) et une borne de tension alternative (8) de l'onduleur (1) qui est prévue pour connecter un conducteur de phase ou un conducteur neutre d'un réseau sous tension alternative, et
- un agencement de circuit (2) pour déterminer une résistance d'isolement, qui comprend une résistance (9) disposée électriquement en parallèle avec l'un des dispositifs d'isolation (6a, 6b), **caractérisé en ce que** le procédé comprend les étapes suivantes :
- la commutation de celle des sectionneurs (6a, 6b) auxquels la résistance (9) est disposée en parallèle dans un état non conducteur et l'autre des sectionneurs (6b, 6a) dans un état conducteur,
- la mesure d'une première valeur de tension d'une tension (V) tombant entre une borne de sortie (11) de la résistance (9) et le premier pôle de la tension continue entre circuits (13) tandis que le premier pôle de la tension continue entre circuits (13) est relié à la borne de tension alternative (8),
- la mesure d'une deuxième valeur de tension de la tension (V) qui chute entre la borne de sortie (11) de la résistance (9) et le premier pôle de la tension continue entre les circuits (13) tandis que le deuxième pôle du circuit intermédiaire de tension continue (13) est relié à la borne de tension alternative (8), et
- Détermination de la résistance d'isolement en fonction des valeurs de tension mesurées.

7. Procédé selon la revendication 6, **caractérisé en ce que le** premier pôle et le deuxième pôle du circuit intermédiaire CC (13) sont reliés chacun à la borne CA (8) en commutant respectivement un premier et un deuxième des éléments de commutation (4) du demi-pont (3) dans un état conducteur.

8. Procédé selon l'une des revendications précédentes 6 à 7, **caractérisé en ce que** le raccordement du premier pôle ou du deuxième pôle, respectivement, du circuit intermédiaire CC (13) à la borne CA (8) s'effectue en alternance avec une fréquence qui est au moins un facteur 10 en dessous de la fréquence secteur, et **en ce que** les composantes de fréquence secteur sont filtrées lors de la mesure des première et deuxième valeurs de tension.
